# EUROPEAN PATENT SPECIFICATION

(11) **EP 3 565 017 B1**
(45) Date of publication and mention of the grant of the patent: **20.07.2022**
(21) Application number: 17886970.7
(22) Date of filing: 26.12.2017
(51) Int. Cl.: H01L 51/54

(54) **ELECTROCHEMICAL LIGHT EMITTING CELL**
ELEKTROCHEMISCHE LICHTEMITTIERENDE ZELLE
CELLULE ÉLECTROLUMINESCENTE ÉLECTROCHIMIQUE

(30) Priority: 27.12.2016 JP 2016254053
(43) Date of publication of application: 06.11.2019
(73) Proprietor: Japan Advanced Institute of Science and Technology, Ishikawa 923-1292 (JP); Nisshinbo Holdings Inc., Tokyo 103-8650 (JP)
(72) Inventor: MURATA Hideyuki, Nomi-shi Ishikawa 923-1292 (JP); TAKAGI Manato, Nomi-shi Ishikawa 923-1292 (JP); SUZUKI Takato, Nomi-shi Ishikawa 923-1292 (JP); MASUDA Gen, Chiba-shi Chiba 267-0056 (JP); YUYAMA Kanako, Chiba-shi Chiba 267-0056 (JP)
(74) Representative: Cabinet Beau de Loménie
(86) International application number: PCT/JP2017/046722
(87) International publication number: WO 2018/124102

(56) References cited:
- EP-A1- 2 730 582
- WO-A1-2009/020038
- WO-A1-2016/056529
- WO-A1-2016/093135
- WO-A1-2016/181726
- JP-A- 2007 204 749
- JP-A- 2013 014 536
- JP-A- 2014 080 388
- JP-A- 2014 082 315
- JP-A- 2015 216 095
- JP-A- 2016 096 328
- JP-A- 2017 036 234
- JP-A- 2017 193 510

## Description

### TECHNICAL FIELD

The present invention relates to a light-emitting electrochemical cell having a light-emitting layer containing an ionic compound such as an ionic liquid together with a light-emitting material.

### BACKGROUND ART

Organic electroluminescence (organic EL) devices are thin, lightweight self-luminous devices requiring no backlight and are used in the field of displays and lighting equipment. However, organic EL devices involve a multilayer structure sandwiched between a pair of electrodes, the multilayer structure being constituted by a hole injection layer, a hole transport layer, a light-emitting layer, an electron transport layer, and an electron injection layer, all of which are extremely thin layers. Thus, organic EL devices pose difficulty in manufacturing cost reduction and are likely to suffer defects such as leakage.

Light-emitting electrochemical cells (LECs) are self-luminous devices including a light-emitting layer made of a light-emitting material to which an electrolyte has been added. Light-emitting electrochemical cells need not have a multilayer structure like those included in organic EL devices and are easily compatible with mass production processes based on film formation using liquid solutions. Light-emitting electrochemical cells are being developed as thin self-luminous devices that overcome the drawbacks of organic EL devices.

Addition of an ionic liquid to a light-emitting layer of a light-emitting electrochemical cell has been proposed. In Patent Literature 1, an ionic liquid containing a quaternary ammonium ion or a quaternary phosphonium ion as a cation is incorporated in a light-emitting layer in order to achieve increased luminance and uniform surface emission. Ionic liquids are ionic compounds which have low melting points and which may, depending on their type, be liquid at or around room temperature. Addition of an ionic compound ensures ion mobility and allows easy formation of an electrical double layer, thereby promoting injection of holes and electrons. Patent Literature 1 mentions hexafluorophosphate (PF6), trifluoromethanesulfonate (TF), bis(trifluoromethanesulfonyl)imide (TFSI), and p-toluenesulfonate (PTS) as examples of the constituent anion of the ionic liquid (paragraph [0037]).

Document JP2016096328 (A) discloses a light-emitting electrochemical cell comprising an ionic compound, and the ionic compound containing a cation having a silicon atom.

### CITATION LIST

### Patent Literature

Patent Literature 1: JP 2015-216095 A

### SUMMARY OF INVENTION

### Technical Problem

Patent Literature 1 presents examples and comparative examples in which experiments were conducted using TFSI exclusively as the anion to evaluate the influence of the type of the cation. In order to improve the light emission characteristics of a light-emitting electrochemical cell, it is desirable to make an investigation of not only the cation of the ionic compound used but also the anion. It is therefore an object of the present invention to discover an anion suitable for improvement in light emission characteristics and provide a light-emitting electrochemical cell with improved light emission characteristics by addition of an ionic compound containing the anion.

### Solution to Problem

The present invention provides a light-emitting electrochemical cell including a first electrode, a second electrode, and a light-emitting layer disposed between the first electrode and the second electrode, wherein
the light-emitting layer contains an ionic compound, and
the ionic compound contains an anion having a silicon atom.

The silicon atom may be contained in the anion as a silicon atom of a silicon-containing group represented by the following formula (1a): 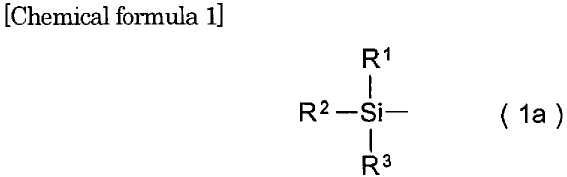 wherein R¹, R², and R³ are each independently an alkyl group having 1 to 4 carbon atoms, and two alkyl groups selected from R¹, R², and R³ are optionally bonded to each other to form an alkylene group having 4 or 5 carbon atoms and constituting a cyclic structure together with the silicon atom.

### Advantageous Effects of Invention

The present invention provides a light-emitting electrochemical cell having a light-emitting layer to which has been added an ionic compound containing an anion suitable for improvement in light emission characteristics, in particular improvement in light emission efficiency.

### BRIEF DESCRIPTION OF DRAWINGS

FIG. 1 is a cross-sectional view schematically showing an embodiment of a light-emitting electrochemical cell according to the present invention.
FIG. 2 shows light emission characteristics (power efficiency) measured in Examples and Comparative Examples.
FIG. 3 shows light emission characteristics (current efficiency) measured in Examples and Comparative Examples.
FIG. 4 shows the relationship between the ratio of an ionic compound to a light-emitting material and the light emission characteristics (power efficiency).
FIG. 5 shows the relationship between the ratio of an ionic compound to a light-emitting material and the light emission characteristics (current efficiency).

### DESCRIPTION OF EMBODIMENTS

Hereinafter, preferred embodiments of the present invention will be described. The following description is not intended to limit the present invention to particular embodiments.

### <Layer configuration of light-emitting electrochemical cell>

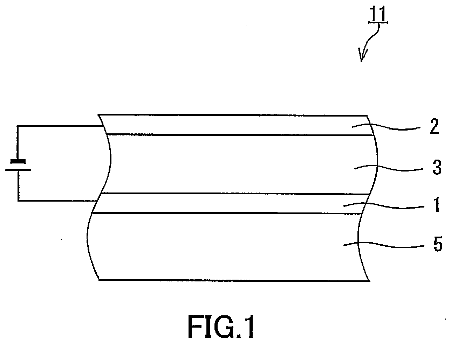

FIG. 1 shows a cross-section of a light-emitting electrochemical cell 11 according to an embodiment of the present invention. The light-emitting electrochemical cell 11 includes a light-emitting layer 3 and first and second electrodes 1 and 2 constituting an electrode pair for applying voltage to the light-emitting layer 3, and further includes a substrate 5. The substrate 5 supports the light-emitting layer 3 and the electrodes 1 and 2, and serves to impart a practical level of mechanical strength to the cell 11. The first electrode 1 is an anode, and the second electrode 2 is a cathode. The first electrode 1 and the second electrode 2 are respectively disposed on the principal surfaces of the light-emitting layer 3 that face in opposite directions, and the electrodes 1 and 2 sandwich the light-emitting layer 3 in the thickness direction of the light-emitting layer 3.

In the light-emitting electrochemical cell 11, the first electrode 1 may be a cathode, and the second electrode 2 may be an anode. A hole injection layer may be interposed between the electrode serving as an anode and the light-emitting layer 3, and an electron injection layer may be interposed between the electrode serving as a cathode and the light-emitting layer 3. It should be noted that the hole injection layer and the electron injection layer are not essential layers for the light-emitting electrochemical cell. One of these layers (e.g., the hole injection layer alone) may be provided. Another layer such as a protective layer may be added to the light-emitting electrochemical cell 11.

### <Materials (other than ionic compound) of layers and substrate>

Materials forming the layers and substrate, other than ionic compounds, will be outlined hereinafter.

### (Substrate)

The substrate 5 can be made of any of various inorganic, organic, or metal materials as long as the substrate 5 is suitable for imparting an appropriate strength to the light-emitting electrochemical cell. The use of a transparent substrate made of a transparent material allows light to be directed to the outside from the light-emitting layer 3 through the substrate 5. From this viewpoint, preferred materials are transparent resins typified by polyethylene terephthalate (PET) and various types of glass. It should be understood that a substrate 5 made of a non-transparent material may be used when light is transmitted to the side where the substrate 5 is not located (the upper side in FIG. 1).

### (Electrodes)

The first electrode 1 and second electrode 2 can be made of any of various conductive materials. Examples of typical conductive materials include metals such as gold, silver, copper, platinum, palladium, magnesium, aluminum, calcium, sodium, cesium, nickel, chromium, molybdenum, and tungsten. Alloys or laminated films containing at least one of the metals mentioned above as examples may be used as the conductive materials. Also suitable for use in the electrodes 1 and 2 are metal oxides such as ITO (tin-doped indium oxide), ATO (antimony-doped tin oxide), AZO (aluminum-doped zinc oxide), IZO (indium-doped zinc oxide), and FTO (fluorine-doped tin oxide) and transparent conductive materials such as single-layer graphene and multi-layer graphene. When the electrodes 1 and 2 are formed on the surface of a transparent substrate, it is preferable that the electrodes 1 and 2 should each be a transparent electrode made of a transparent conductive material. When a non-transparent electrode material is used, it is preferable that the electrodes be formed in a grid pattern. The appropriate thickness of the first electrode 1 and second electrode 2 depends on the materials used and the form of the electrodes. When the electrodes are uniform thin-film electrodes, the thickness of the electrodes is 10 nm to 1 µm and preferably 20 to 600 nm. When the electrodes are grid-patterned electrodes, the thickness is 10 nm to 100 µm and preferably 1 to 10 µm.

### (Hole injection layer)

The hole injection layer is made of a material suitable for lowering the barrier against injection of holes into the light-emitting layer from the anode and is formed as necessary in consideration of, for example, the anode material and light-emitting material used. Examples of typical materials for forming the hole injection layer include CuPc (copper phthalocyanine), PEDOT:PSS (poly(3,4-ethylenedioxythiophene) polystyrene sulfonate), m-MTDATA (4,4',4"-tris(N-3-methylphenyl-N-phenylamino)triphenylamine), and HAT-CN (1,4,5,8,9,11-hexaazatriphenylenehexacarbonitrile). The thickness of the hole injection layer is, for example, 1 to 300 nm and preferably 100 nm or less.

### (Electron injection layer)

The electron injection layer is made of a material suitable for lowering the barrier against injection of electrons into the light-emitting layer from the cathode and is formed as necessary in consideration of, for example, the cathode material and light-emitting material used. Examples of typical materials for forming the electron injection layer include LiF, CsF, NaF, Li₂O, CaO, and Liq. The thickness of the electron injection layer is 1 to 300 nm and preferably 100 nm or less.

### (Light-emitting layer/light-emitting material)

The light-emitting layer 3 contains a light-emitting material and an ionic compound. The light-emitting material will be described hereinafter. Examples of typical light-emitting materials include an organic high-molecular-weight light-emitting material and a metal complex. The thickness of the light-emitting layer is, for example, 10 nm to 50 µm and preferably 50 to 200 nm.

The organic high-molecular-weight light-emitting material acts as a carrier medium of electrons and holes by being doped with the anion and cation and becomes excited as a result of coupling of electrons and holes to emit light. Examples of the organic high-molecular-weight light-emitting material include π-conjugated polymers, in particular polymers or copolymers produced using p-phenylenevinylene, fluorene, 1,4-phenylene, thiophene, pyrrole, p-phenylene sulfide, benzothiadiazole, bithiophene, or a derivative thereof as a monomer. Examples of the derivative include those resulting from introduction of a substituent selected from an alkyl group having 1 to 20 carbon atoms, an alkoxy group having 1 to 20 carbon atoms, an aryl group having 6 to 18 carbon atoms, and a group represented by [(-CH₂CH₂O-)ₙCH₃] (n is an integer of 1 to 10). Specific examples of the organic high-molecular-weight light-emitting material include SY (Super Yellow; poly(1,4-phenylene vinylene) derivative), F8BT (poly(9,9'-dioctylfluorene-co-benzothiadiazole)), MEH-PPV (poly[2-methoxy-5-(2-ethylhexyloxy)-1,4-phenylenevinylene]), and PDHF (poly(9,9-dihexylfluorene)). These may be used in combination as appropriate.

The metal complex is not particularly limited and may be any metal complex that exhibits light-emitting property in the present invention; for example, an aluminum complex, a zinc complex, an iridium complex, a ruthenium complex, a platinum complex, a scandium complex, or a cadmium complex can be used. Specific examples of the metal complex include tris(8-quinolinate)aluminum complex, tris(4-methyl-8-quinolinolate)aluminum complex, bis(8-quinolinolate)zinc complex, tris(4-methyl-5-trifluoromethyl-8-quinolinolate)aluminum complex, tris(4-methyl-5-cyano-8-quinolinolate)aluminum complex, bis(2-methyl-5-trifluoromethyl-8-quinolinolate)[4-(4-cyanophenylphenolate] aluminum complex, bis(2-methyl-5-cyano-8-quinolinolate)[4-(4-cyanophenyl)phenolate]aluminum complex, tris(8-quinolinolate)scandium complex, bis[8-(p-tosyl)aminoquinoline]zinc complex, ruthenium complexes whose ligand is bipyridyl (bpy) or a derivative thereof or phenanthroline or a derivative thereof, and octaethyl(porphyrin)platinum complex. These materials may be used in combination as appropriate. Examples of the ruthenium complex and the iridium complex further include tris(4,4'-di-tert-butyl-2,2'-bipyridine)ruthenium complex, bis(2,2'-bipyridine)[4,4'-bis(N-hexylcarboxamido)-2,2'-bipyridine]ruthenium complex, bis(2-phenylpyridine)(4,4'-di-tert-butyl-2,2'-bipyridine)iridium complex, bis(2-phenylpyridine)(6-phenyl-2,2'-bipyridine)iridium complex, and bis(1-phenylpyrazole)(5,6-dimethyl-1,10-phenanthroline)iridium complex. The anion added together with the cation of any of the above metal complexes (organic metal complexes) is not particularly limited, and a known anion such as hexafluorophosphate can be used.

An organic low-molecular-weight light-emitting material may be used as the light-emitting material. Any organic low-molecular-weight light-emitting material proposed for use as a light-emitting material in organic EL devices may be used as appropriate.

Quantum dots may be used as the light-emitting material. Examples of the quantum dots include: quantum dots made of C, Si, Ge, Sn, P, Se, or Te alone; quantum dots made of a combination of Zn, Cd, Hg, or Pb which converts to a divalent cation and O, S, Se, or Te which converts to a divalent anion; quantum dots made of a combination of Ga or In which converts to a trivalent cation and N, P, As, or Sb which converts to a trivalent anion; and quantum dots made of a composite or mixture of these combinations. Specific examples of the combinations include GaN, GaP, CdS, CdSe, CdTe, InP, InN, ZnS, In₂S₃, ZnO, CdO, and composites or mixtures thereof. As regards multiple combinations, chalcopyrite compounds can also be suitably used, and examples include CuAlS₂, CuGaS₂, CuInS₂, CuAlSe₂, CuGaSe₂, AgAlS₂, AgGaS₂, AgInS₂, AgAlSe₂, AgGaSe₂, AgInSe₂, AgAlTe₂, AgGaTe₂, AgInTe₂, Cu(In, Al)Se₂, Cu(In, Ga)(S, Se)₂, Ag(In, Ga)Se₂, and Ag(In, Ga)(S, Se)₂. Perovskite compounds can also be suitably used, and examples include CsPbX₃ (X = I, Br, or Cl) and CH₃NH₃PbX₃ (X = I, Br, or Cl). These may be used in combination as appropriate.

The light-emitting layer 3 may contain a material other than the light-emitting material and the ionic compound. Examples of the material other than the light-emitting material and the ionic compound include a surfactant, a polymer component (such as polyethylene oxide) for improvement in electrical conductivity, and a polymer component (such as polystyrene or polymethyl methacrylate (PMMA)) for improvement in film formability. It should be noted that the amount by mass of this material is preferably 90 parts or less, more preferably 50 parts or less, and particularly preferably 30 parts or less with respect to 100 parts of the total mass of the light-emitting layer 3.

### <Ionic compound>

The ionic compound is a compound composed of oppositely charged ions, i.e., an anion and a cation; that is, the ionic compound is a salt in the broad sense. An ionic liquid having a low melting point is suitable as the ionic compound. The term "ionic liquid" generally refers to an ionic compound (salt in the broad sense) having a melting point of 150°C or lower, or 100°C or lower in some cases. The ionic compound may be a room-temperature ionic liquid which is liquid at room temperature (25°C) or may be solid at room temperature. Hereinafter, the anion and cation of the ionic compound added together with the light-emitting material to the light-emitting layer 3 will be described.

### (Anion)

As previously mentioned, the anion may be any anion containing a silicon atom; for example, the anion has a group having a silicon atom (silicon-containing group) and an anion group. Examples of such an anion include an anion in which the silicon-containing group and the anion group are linked via a hydrocarbon group, preferably via an alkylene group. The alkylene group may be linear, branched, or cyclic and is preferably linear. The number of carbon atoms in the alkylene group is, for example, 2 to 20, preferably 2 to 12, more preferably 2 to 8, even more preferably 2 to 6, particularly preferably 2 to 4, and more particularly preferably 2 or 3. Examples of the silicon-containing group include a silicon-containing group in which three bonds of the silicon atom are all bonds to hydrocarbon groups and the remaining bond of the silicon atom is a bond to the anion group via another group such as a hydrocarbon group as mentioned above. The hydrocarbon groups attached to the silicon atom by the three bonds may be aromatic and are preferably aliphatic. Specifically, alkyl groups are suitable. The alkyl groups may be linear, branched, or cyclic. The number of carbon atoms in the alkyl groups is, for example 1 to 20, preferably 1 to 8, more preferably 1 to 6, and even more preferably 1 to 4. A particularly preferred silicon-containing group is represented, for example, by the following formula (1a). In the formula (1a), the three alkyl groups R¹ to R³ bonded to the silicon atom are each independently an alkyl group having 1 to 4 carbon atoms. All of R¹ to R³ may be different alkyl groups; however, when all of R¹ to R³ are the same alkyl group, the synthesis is cost-effective. Any two alkyl groups selected from R¹ to R³ may be bonded to each other to form an alkylene group having 4 or 5 atoms and constituting a cyclic structure together with the silicon atom. When R² and R³ form an alkylene group, the silicon-containing group in the formula (1a) is represented, for example, by formula (1a-1).

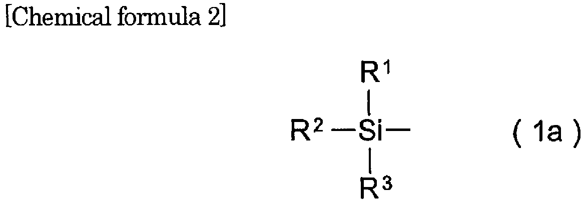

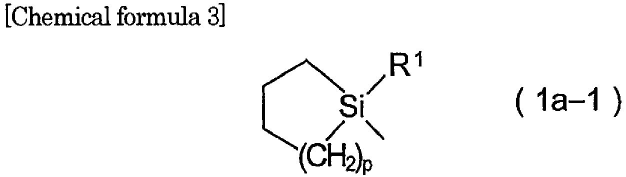

In the formula (1a-1), p is 1 or 2.

The alkyl groups R¹ to R³ may be linear, branched, or cyclic. Each of R¹ to R³ is, for example, a methyl group, an ethyl group, an n-propyl group, an i-propyl group, an n-butyl group, an s-butyl group, an i-butyl group, or a t-butyl group, more preferably a methyl group (-Me) or an ethyl group (-Et), and particularly preferably a methyl group. In view of ease and cost-effectiveness of synthesis, it is preferable that R¹ to R³ be the same. When all of R¹ to R³ are methyl groups, the silicon-containing group in the formula (1a) is represented by formula (1a-2).

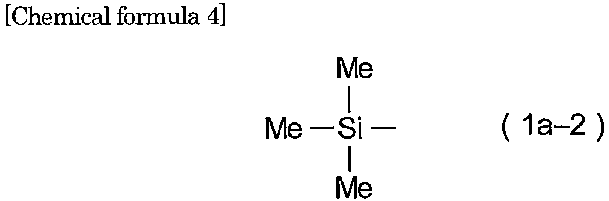

The anion having a silicon atom has been found to make a greater contribution to improvement in light emission efficiency of light-emitting electrochemical cells than anions of conventionally-used ionic compounds. A possible reason for the improvement in light emission efficiency may be that the compatibility with light-emitting materials is increased by the use of the anion which is highly hydrophobic. However, if this is the sole reason for the improvement in light emission efficiency, the use of an anion containing no silicon atom and having especially high hydrophobicity (e.g., a highly hydrophobic long-chain alkyl group such as an n-dodecyl group) should offer the highest light emission efficiency. Referring to the experimental results described later, the anion having a silicon atom is thought to make a contribution to improvement in light emission efficiency of light-emitting electrochemical cells, and this contribution cannot be explained solely by the level of the hydrophobicity and is considered due to the very presence of the silicon atom.

The anion having a silicon-containing group contains an anion group in addition to the silicon-containing group. The anion group is not particularly limited, and an oxoanion group, in particular a monovalent oxoanion group, is suitable. It is preferable that the anion group be one represented by -SO₃-, -OSO₃-, or -OP(OR⁰)O₂-, in particular by -SO₃- or -OSO₃-. That is, a sulfonate ion group (-SO₃-), a sulfate ester ion group (-OSO₃-), or a phosphate ester ion group (OP(OR⁰)O₂-) is suitable as the anion group. R⁰ is an alkyl group having 1 to 4 carbon atoms, and specific examples and suitable examples of the alkyl group are as described above for R¹ to R3.

It is suitable that the anion of the ionic compound be a monovalent anion; specifically, it is preferable that the anion be one represented by the following formula (1).

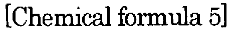

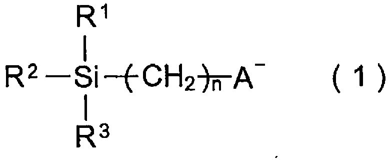

In the formula, n is an integer of 2 to 6 and A⁻ is a monovalent anion group. n is preferably 2 to 4 and more preferably 2 or 3. R¹ to R³ are as described above.

Specific examples of the anion group represented by A⁻ are as described above. When A⁻ is a preferred monovalent oxoanion group as described above, the anion represented by the formula (1) is represented by any of the following formulae (1-1) to (1-3). R⁰ is as described above.

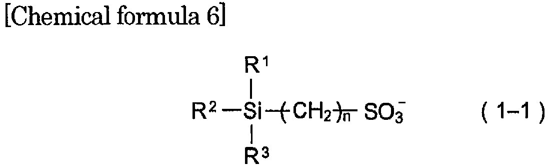

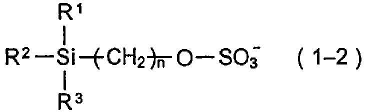

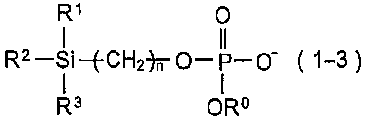

Anions represented by the formula (1) wherein all of R¹ to R³ are methyl groups (-Me) and n is 3 or 2 are shown as formulae (1-4) and (1-5).

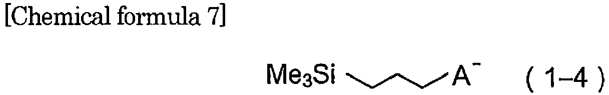

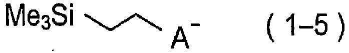

Anions that can be represented both by any one of the formulae (1-1) to (1-3) and by the formula (1-4) or (1-5) are particularly suitable for addition to light-emitting layers of light-emitting electrochemical cells.

An ionic compound containing the anion represented by the formula (1) contains a monovalent, divalent, or highervalence cation. When the cation is a monovalent cation X⁺, this ionic compound is represented by the following formula. The cation will be described in the subsequent paragraphs.

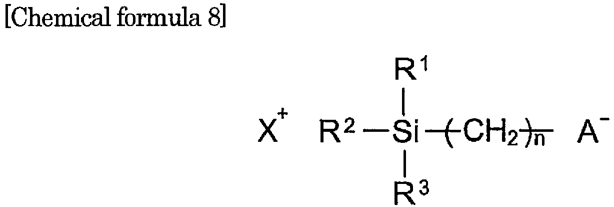

### (Cation)

The type of the cation contained in the ionic compound is not particularly limited, and the cation may be an inorganic ion or an organic ion. Examples of the organic cation include metal ions, in particular monovalent cations such as Li ion and divalent cations such as Mg ion. Examples of the organic ion include: nitrogen atom (N)-containing cations, as exemplified by substituted ammonium ions such as a quaternary ammonium ion; and phosphorus atom (P)-containing cations, as exemplified by substituted phosphonium ions such as a quaternary phosphonium ion. The organic ion may be a dication having two cation groups per molecule. An example of this type of dication is a compound having a linear alkylene group and cation groups bonded to carbon atoms at both terminals of the linear alkylene group. The number of carbon atoms in the linear alkylene group is, for example, 2 to 20. The cation groups are, for example, substituted ammonium and/or phosphonium groups and preferably substituted ammonium groups. In the present specification, the terms "substituted ammonium ion" (or "substituted ammonium group") and "substituted phosphonium ion" (or "substituted phosphonium group") are intended to include quaternary and non-quaternized ions (or groups), namely ions (or groups) composed of a primary to tertiary amine or primary to tertiary phosphine to which a proton is added. Another example of the organic ion is an organic metal complex ion. In the present embodiment, the cation contained in the ionic compound may be at least one selected from a nitrogen atom-containing ion, a phosphorus atom-containing ion, a metal ion, and an organic metal complex ion.

The nitrogen atom-containing ion and the phosphorus atom-containing ion may have a cyclic structure. Examples of the nitrogen atom-containing cation having a cyclic structure include an imidazolium ion, a pyridinium ion, a pyrrolidinium ion, and a piperidinium ion. In the present specification, these terms such as "imidazolium ion" and "piperidinium ion" are used in a broad sense, and specifically refer to ions containing a corresponding cyclic structure (e.g., an imidazole ring for an imidazolium ion). It is preferable that the ionic compound contain, as the cation, at least one selected from a quaternary ammonium ion, a quaternary phosphonium ion, an imidazolium ion, and a pyridinium ion. Examples of the structures of the quaternary ammonium ion, quaternary phosphonium ion, imidazolium ion, and pyridinium ion are respectively shown as formulae (2) to (5) below.

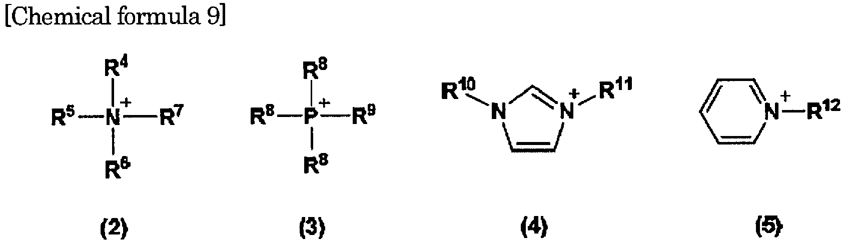

In the formula (2), R⁴ to R⁷ are each independently an alkyl group having 1 to 20, preferably 1 to 4, carbon atoms or an alkoxyalkyl group represented by -(CH2)ₖ-OR. Two groups selected from R⁴ to R⁷ may be bonded to each other to form a cyclic structure together with the nitrogen atom (N⁺) to which the two groups are bonded. k is 1 or 2. R is a methyl group or an ethyl group. Specific examples of R⁴ to R⁷ are as described above for R¹ to R³. The alkoxyalkyl group is specifically a methoxymethyl group, an ethoxymethyl group, a methoxyethyl group, or an ethoxyethyl group and preferably a methoxyethyl group or a methoxymethyl group. When all of R⁴ to R⁷ are alkyl groups, a quaternary ammonium ion in which at least one of the alkyl groups is different in structure from the other alkyl groups is more likely to form an ionic liquid. In this case, the difference in the number of carbon atoms between the at least one alkyl group and the other alkyl groups is preferably 1 or more, more preferably 3 or more, and even more preferably 5 or more.

When two groups selected from R⁴ to R⁷ are bonded to each other to form a cyclic structure together with the nitrogen atom, the other two groups may be bonded to each other to form a spirocyclic structure having the nitrogen atom as a spiro atom. Examples of the cyclic structure include an aziridine ring, an azetidine ring, a pyrrolidine ring, a piperidine ring, an azepane ring, an imidazolidine ring, a pyridine ring, a pyrrole ring, and an imidazole ring. Preferred cyclic structures are a pyrrolidine ring, a piperidine ring, an imidazolidine ring, a pyridine ring, a pyrrole ring, and an imidazole ring, and particularly preferred cyclic structures are a pyrrolidine ring and an imidazolidine ring. Preferred as the spiro ring is a 1,1'-spirobipyrrolidine ring.

Examples of the cation (quaternary ammonium ion) represented by the formula (2) include ions represented by the following formulae (2-1) to (2-4).

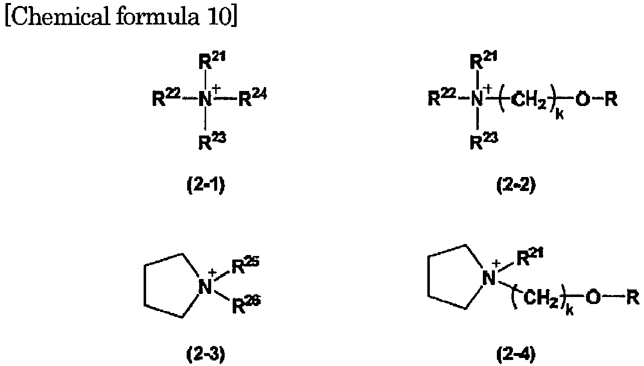

In the formulae (2-1) to (2-4), as described above, k is 1 or 2 and R is a methyl group or an ethyl group. R²¹ to R²⁴ are each independently an alkyl group having 1 to 4 carbon atoms. R²⁵ and R²⁶ are each independently an alkyl group having 1 to 4 carbon atoms. R²⁵ and R²⁶ may be bonded to each other to form a cyclic structure together with the nitrogen atom to which R²⁵ and R²⁶ are bonded.

Specific examples of the cation represented by the formula (2) are shown below.

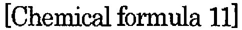

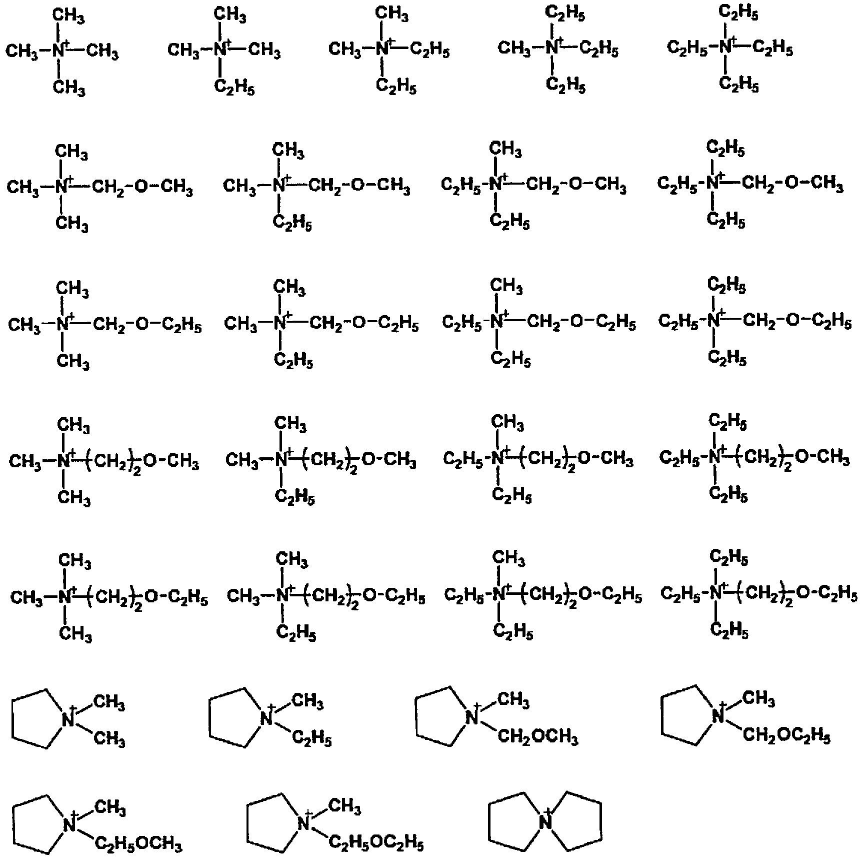

For the cation (quaternary phosphonium ion) represented by the formula (3), R⁸ is an alkyl group having 1 to 20 carbon atoms. This alkyl group may be linear, branched, or cyclic, and is preferably linear. R⁸ may be any of the above specific examples of the alkyl group having 1 to 4 carbon atoms and may also be an n-pentyl group, a cyclopentyl group, an n-hexyl group, a cyclohexyl group, an n-heptyl group, an n-octyl group, an n-nonyl group, an n-decyl group, an n-undecyl group, an n-dodecyl group, an n-tridecyl group, an n-tetradecyl group, an n-pentadecyl group, an n-hexadecyl group, an n-heptadecyl group, an n-octadecyl group, an n-nonadecyl group, or an n-eicosyl group.

R⁹ is an alkyl group having 1 to 20 carbon atoms or an alkoxyalkyl group represented by -(CH₂)ₖ-OR. k is 1 or 2. R is a methyl group or an ethyl group. The alkyl group having 1 to 20 carbon atoms may be linear, branched, or cyclic and is preferably linear. Specific examples of R⁹ include those mentioned above as specific examples of R⁴ to R⁷.

Among quaternary phosphonium ions represented by the formula (3), a quaternary phosphonium ion in which R⁹ is an alkoxyalkyl group represented by -(CH₂)ₖ₋OR is more likely to form an ionic liquid. When R⁹ is an alkyl group, a quaternary phosphonium ion in which R⁸ and R⁹ are different in structure is more likely to form an ionic liquid. In this case, the difference in the number of carbon atoms between R⁸ and R⁹ is preferably 1 or more, more preferably 3 or more, and even more preferably 5 or more.

Specific examples of the cation represented by the formula (3) are shown below.

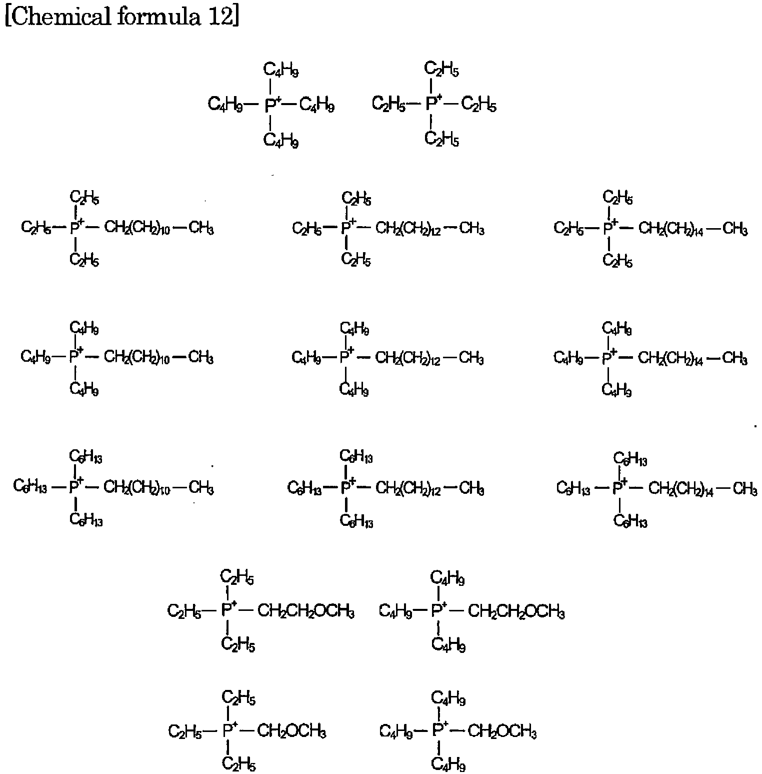

In the formula (4), R¹⁰ and R¹¹ are each independently an alkyl group having 1 to 4 carbon atoms or an alkoxyalkyl group represented by -(CH₂)ₖ-OR. Specific examples of the alkyl group having 1 to 4 carbon atoms, R, and k are as described above.

In the formula (5), R¹² is an alkyl group having 1 to 8 carbon atoms or an alkoxyalkyl group represented by -(CH₂)ₖ-OR. R and k are as described above. As the alkyl group having 1 to 8 carbon atoms there can be used any corresponding one of the above examples.

### (Method for synthesis of ionic compound)

Next, examples of methods for synthesis of ionic compounds illustrated above will be described.

### (Ionic compound containing sulfonate ion (SO₃-) group-containing anion)

An ionic compound containing an anion represented by the formula (1-1) and a cation represented by the formula (2) can be synthesized, for example, by a method disclosed in JP 2014-80388 A. In Examples 1 and 2 of JP 2014-80388 A, synthesis examples of the following ionic compounds are disclosed.

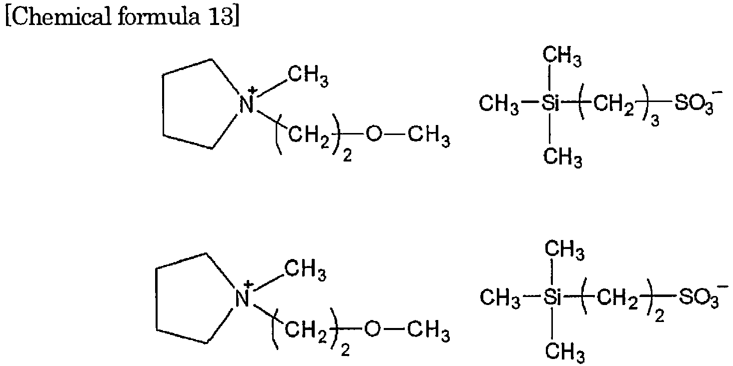

In Examples 1 to 7 of JP 2014-82315 A, synthesis examples of the following ionic compounds are disclosed. The following compounds include only those which are not specifically disclosed in JP 2014-80388 A.

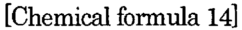

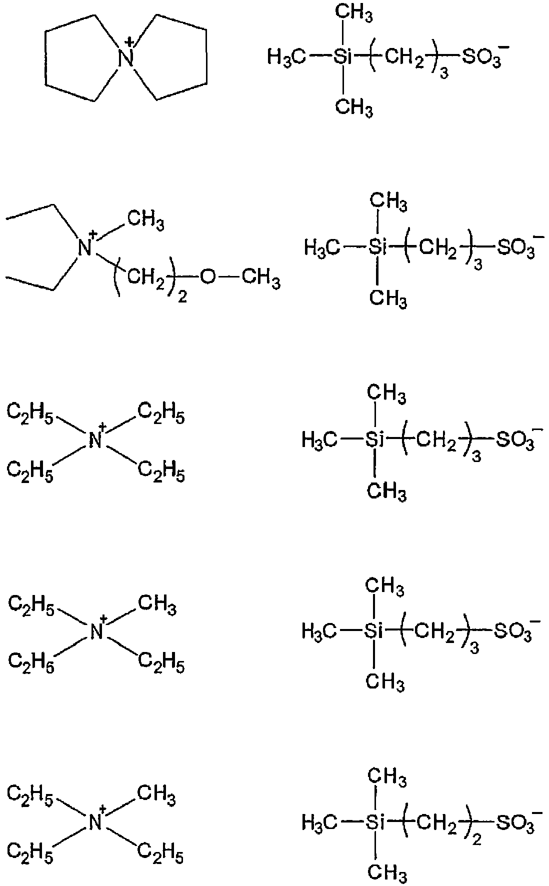

An ionic compound containing an anion represented by the formula (1-1) and a cation represented by the formula (3) can be synthesized, for example, by a method disclosed in JP 2013-14536 A. In Examples of this publication, synthesis examples of the following ionic compounds are disclosed as Examples 1 and 2. According to Examples 1 and 2, it was confirmed that the resulting ionic compounds were liquid.

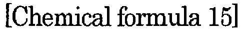

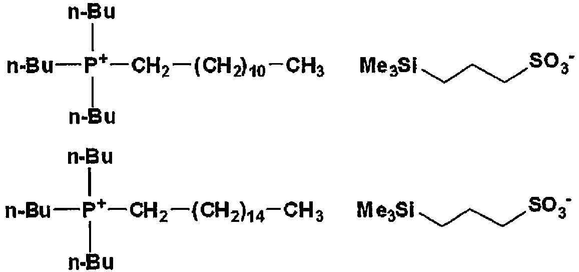

"Bu" denotes a butyl group. The above two room-temperature ionic liquids may be referred to as "BDDP•TMSC3SO3" and "BHDP•TMSC3SO3" hereinafter.

The following ionic compounds can be produced by carrying out the same method as disclosed in JP 2013-14536 A, except that sodium 2-(trimethylsilyl)-1-ethanesulfonate is used instead of sodium 3-(trimethylsilyl)-1-propanesulfonate.

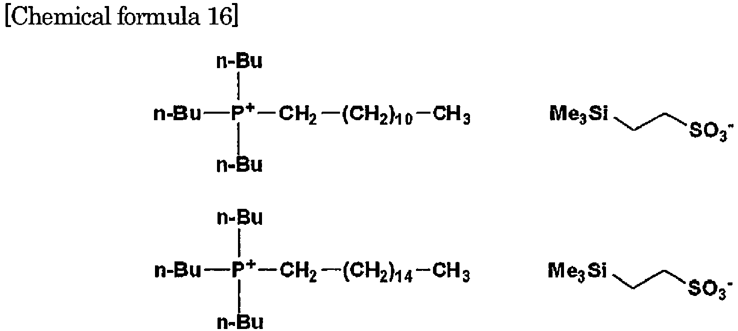

The above two room-temperature ionic liquids may be referred to as "BDDP•TMSC2SO3" and "BHDP•TMSC2SO3" hereinafter.

An example of methods for synthesis of an ionic compound containing an anion represented by the formula (1-1) and a cation represented by the formula (4) will be described below. In this synthesis example, the following ionic compound was synthesized.

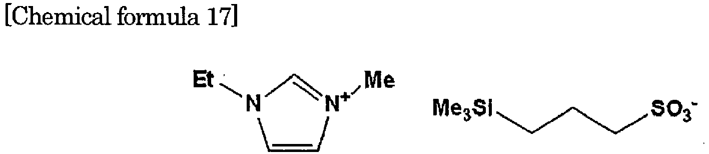

A 15-mL aqueous solution of 3.0 g of ethylmethylimidazolium chloride (manufactured by Tokyo Chemical Industry Co., Ltd.) was added to 40 mL of an anion exchange resin (DS-2, manufactured by Organo Corporation) washed with ion-exchanged water (the indicated volume of the resin is inclusive of added ion-exchanged water, and the same applies hereinafter), and the mixture was left for several hours. DS-2 was removed by filtration, and the filtrate was added to 40 mL of washed DS-2 freshly prepared. The mixture was left for several hours, after which DS-2 was removed by filtration. Next, the filtrate was passed through a column packed with 150 mL of DS-2 (eluent: ion-exchanged water), and a filtrate showing alkalinity was collected. Thus, an aqueous solution of ethylmethylimidazolium hydroxide resulting from complete replacement of chloride by hydroxide was obtained.

A 65-mL aqueous solution of 4.0 g of sodium 3-(trimethylsilyl)-1-propanesulfonate (DSSNa, manufactured by Tokyo Chemical Industry Co., Ltd.) was added to 25 mL of a cation exchange resin (Amberlist 15JS-HG•DRY, manufactured by Organo Corporation) washed with ion-exchanged water (the indicated volume of the resin is inclusive of added ion-exchanged water, and the same applies hereinafter), and the mixture was left for several hours. 15JS-HG•DRY was removed by filtration, and the filtrate was added to 25 mL of washed 15JS-HG•DRY freshly prepared. The mixture was left for several hours, after which 15JS-HG•DRY was removed by filtration. Next, the filtrate was passed through a column packed with 100 mL of 15JS-HG•DRY (eluent: ion-exchanged water), and a filtrate showing acidity was collected. Thus, an aqueous solution of 3-(trimethylsilyl)-1-propanesulfonic acid resulting from complete replacement of sodium by hydrogen was obtained.

The obtained aqueous solution of ethylmethylimidazolium hydroxide and aqueous solution of 3-(trimethylsilyl)-1-propanesulfonic acid were mixed, and the pH of the mixed solution was adjusted to 6 to 8. Water was removed from the mixed solution with an evaporator first and then with a vacuum pump, and thus the ionic compound was obtained as a white solid (amount: 5.3 g, yield: 92%, on a DSSNa basis). By referring to this production example, various ionic compounds containing a silicon-containing sulfonate ion as the anion and an imidazolium ion as the cation can be obtained.

The method for synthesis of an ionic compound containing an anion represented by the formula (1-1) and a cation represented by the formula (5) may be a known method; for example, such an ionic compound can be obtained by reacting pyridine and a halogenated alkyl to synthesize a desired pyridinium salt and then carrying out the method as described above using the pyridinium salt instead of the imidazolium salt.

### (Ionic compound containing sulfate ester ion (OSO₃-) group-containing anion)

An ionic compound containing an anion represented by the formula (1-2) can be synthesized, for example, by a method described below. This method is a synthesis example for obtaining the following ionic compound.

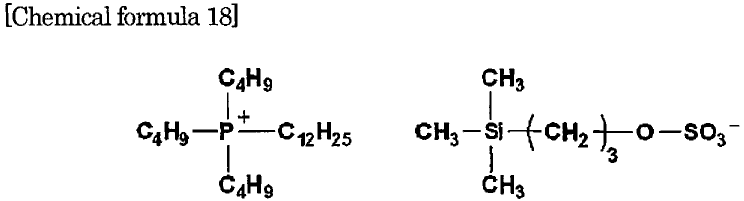

The alkyl groups contained in the cation of the ionic compound are all linear. The above room-temperature ionic liquid may be referred to as "BDDP•TMSC3SO4" hereinafter.

1.0 equivalent of trimethylsilylpropanol (manufactured by Sigma-Aldrich Co., LLC), 1.1 equivalents of amidosulfuric acid (manufactured by Wako Pure Chemical Industries, Ltd.), and 0.2 equivalents of urea (manufactured by Wako Pure Chemical Industries, Ltd.) were mixed and heated to 150°C under stirring in a nitrogen atmosphere. After the temperature reached 150°C, the mixture was continuously heated under stirring for 6 hours and then left to cool to room temperature. To the resulting solid was added ethyl acetate (manufactured by Wako Pure Chemical Industries, Ltd.) in an amount such that the solid was fully immersed, and the solid was crushed with a medicine spoon. Stirring was performed for 1 hour, after which solids were collected by filtration under reduced pressure and dried. The following compound A was obtained in a form containing a slight amount of urea (yield: 79%).

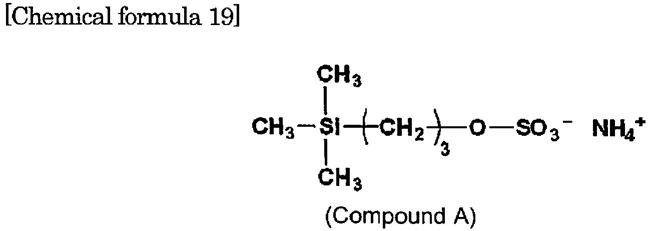

To 1.0 equivalent of the obtained compound A was added HISHICOLIN PX-412C (50% aqueous solution of dodecyltributylphosphonium chloride, manufactured by Nippon Chemical Industrial Co., Ltd.) in an amount such that the amount of dodecyltributylphosphonium chloride was 1.0 equivalent, and the mixture was stirred for 30 minutes. To the reaction liquid separated into two layers was added ethyl acetate (manufactured by Wako Pure Chemical Industries, Ltd.) in the same volume as HISHICOLIN PX-412C, and the liquid was further stirred for 3 hours. After the liquid was allowed to stand still, the lower aqueous layer was separated, and ion-exchanged water (the volume was half that of HISHICOLIN PX-412C) and 0.15 equivalents of the compound A were added to the organic layer. After stirring for 3 hours, liquid-liquid separation was performed again, and the resulting organic layer was washed with water four times. The solvent and water were removed from the organic layer with an evaporator first and then with a vacuum pump, and thus an ionic compound was obtained in the form of a colorless, transparent liquid (yield: 92%).

In a synthesis example where synthesis is performed in the same manner as above except that HISHICOLIN PX-416C (50% aqueous solution of hexadecyltributylphosphonium chloride, manufactured by Nippon Chemical Industrial Co., Ltd.) is used in place of HISHICOLIN PX-412C, the following ionic compound can be obtained as a colorless, transparent liquid.

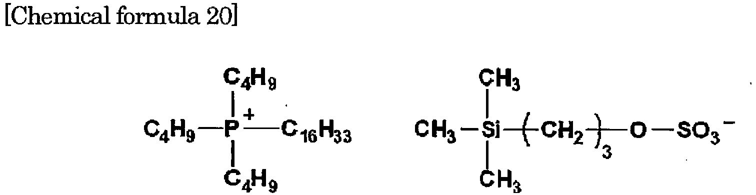

The above room-temperature ionic liquid may be referred to as "BHDP•TMSC3SO4" hereinafter.

Synthesis of other ionic compounds containing a sulfate ester ion-containing anion is not described herein since they can be synthesized by referring as appropriate to the synthesis examples described above for ionic compounds containing a sulfonate ion-containing anion or the synthesis examples described later.

### (Ionic compound containing phosphate ester ion (OP(OR⁰)O₂-) group-containing anion)

An ionic compound containing an anion represented by the formula (1-3) can be synthesized, for example, by the following scheme A.

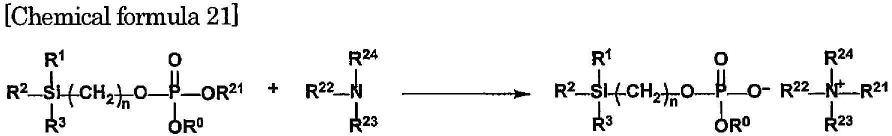

R⁰, R¹ to R³, R²¹ to R²⁴, and n are as described above. The presented scheme is one involving a cation represented by the formula (2-1), and similar schemes can be employed for other cations. For example, in the case of a cation represented by the formula (2-2) or (2-4), a compound corresponding to the cation form which R²¹ has been removed may be used instead of NR²²R²³R²⁴. This synthesis method is particularly preferred when R⁰ and R²¹ are the same. In other cases, when a mixture has been obtained, the mixture can be subjected to a separation process using a known purification technique such as column chromatography to obtain the target compound. When an ionic compound containing a cation represented by the formula (3), (4), or (5) is to be obtained, tertiary phosphine, 1-alkylimidazole, or pyridine may be used.

The scheme A can be accomplished either in the absence of any solvent or with the use of a solvent. The reaction temperature is typically 60 to 120°C and preferably 80 to 100°C. The reaction time may be chosen as appropriate depending on the degree of reaction and is typically several hours to a dozen or so hours.

The phosphate ester used in the scheme A can be synthesized according to the following scheme B, although the phosphate ester may be synthesized by another known method.

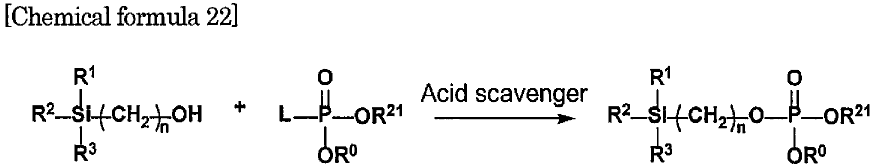

Also in this scheme, R⁰, R¹ to R³, R²¹, and n are as described above. L is a halogen atom such as a chlorine atom, a bromine atom, or an iodine atom.

The scheme B can be carried out using commercially-sold starting materials and an acid scavenger for use in phosphate ester synthesis. The scheme B can also be accomplished either in the absence of any solvent or with the use of a solvent.

An ionic compound containing an anion represented by the formula (1-3) may be produced by a neutralization process using an ion exchange resin. When ionic compounds containing a cation represented by the formula (3) are obtained by this method, for example, the following two compounds, silicon-containing phosphate ester salts as synthesized by the above-described synthesis method, and easily-available quaternary phosphonium salts can be used. Z is an anion. Z is preferably a halogen ion and particularly preferably a chloride ion or bromide ion.

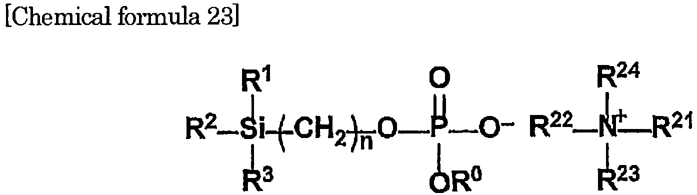

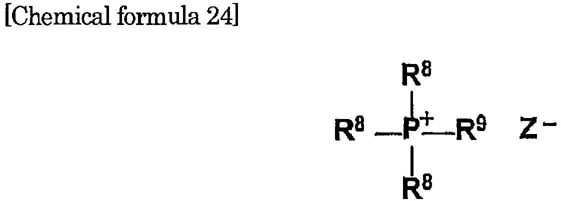

In the neutralization process, the above two compounds (salts), namely the silicon-containing phosphate ester salt (P-0⁻) and the quaternary phosphonium salt (Z-), may be respectively converted to a silicon-containing phosphate group-containing ester (P-OH) and a quaternary phosphonium hydroxide (OH⁻) using a cation exchange resin and an anion exchange resin, and then the ester and the hydroxide may be mixed.

Hereinafter, a synthesis example of an ionic compound containing an anion represented by the formula (1-3) will be described. First, the following silicon-containing phosphate ester was synthesized.

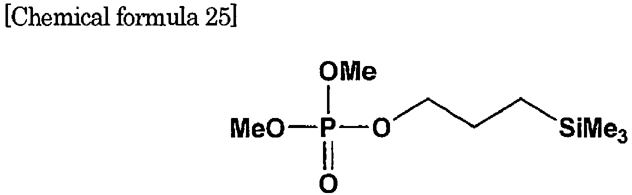

1.00 part by mass of 3-trimethylsilyl-1-propanol (manufactured by Kanto Chemical Co., Inc.) and 1.21 parts by mass of dimethyl chlorophosphate (manufactured by Sigma-Aldrich Co., LLC.) were placed in a reaction vessel. While the contents of the vessel were cooled with ice under stirring, 0.66 parts by mass of pyridine (manufactured by Wako Pure Chemical Industries, Ltd.) was slowly added dropwise. After the dropwise addition, the stirring was continued overnight, and water was introduced into the reaction liquid to terminate the reaction. Extraction by addition of ethyl acetate (manufactured by Wako Pure Chemical Industries, Ltd.) was repeated twice, and the collected organic layer was washed with saturated saline solution and then dried over magnesium sulfate (manufactured by Wako Pure Chemical Industries, Ltd.). The dried organic layer was filtered under reduced pressure, then the filtrate was concentrated with an evaporator, and the residue was transferred to another vessel and subjected to distillation under reduced pressure. A fraction with a boiling point of 105 to 106°C/3 mmHg was collected, and thus 1.06 parts by mass of the target compound, namely the silicon-containing phosphate ester, was obtained (yield: 59%).

Hereinafter, a synthesis example of the following ionic compound will be described.

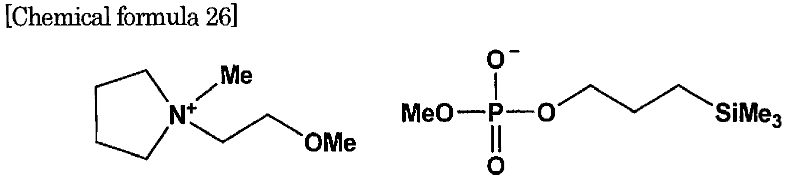

1.51 parts by mass of pyrrolidine (manufactured by Wako Pure Chemical Industries, Ltd.) and 1.00 part by mass of 2-methoxyethyl chloride (manufactured by Kanto Chemical Co., Inc.) were mixed and reacted under reflux for 5 hours. After the reaction, the reaction liquid became separated into two layers, of which the lower layer solidified while the reaction liquid was left to cool for some time. Only the upper layer was collected by decantation and purified by distillation under reduced pressure. As a result of this distillation, 0.96 parts by mass of the target compound, namely N-2-methoxyethylpyrrolidine (boiling point: 76°C/vapor pressure: 45 mmHg), was obtained (yield: 70%). To 1.00 part by mass of the obtained N-2-methoxyethylpyrrolidine was added 1.65 parts by mass of the silicon-containing phosphate ester obtained above, and the reaction was allowed to proceed under stirring at 100°C for 5 hours. The reaction liquid was cooled to room temperature, then a small amount of ethyl acetate was added to lower the viscosity of the liquid, and the liquid was transferred to a separatory funnel. Upon addition of hexane, the liquid was separated into two layers. Collection of the lower layer, addition of a small amount of ethyl acetate for viscosity lowering, and transfer to a separatory funnel were further repeated twice, and the resulting lower layer was washed. The lower layer was vacuum-dried, and thus the target compound, namely the ionic compound, was obtained in an approximately stoichiometric amount (1.53 parts by mass, yield: 99%). This ionic compound was liquid at room temperature.

The following ionic compound was also successfully obtained in an approximately stoichiometric amount by the same synthesis method except that triethylamine (manufactured by Wako Pure Chemical Industries, Ltd.) was used in place of N-2-methoxyethylpyrrolidine.

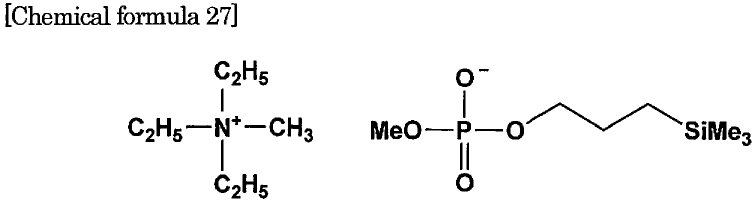

Hereinafter, a synthesis example of the following ionic compound will be described. The alkyl groups contained in the cation of the following ionic compound are all linear.

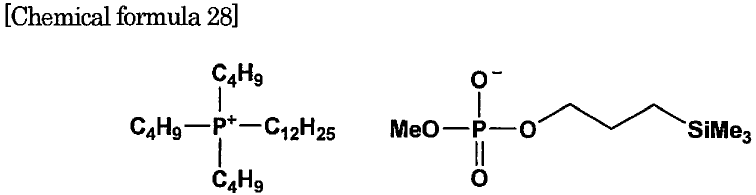

12-mL methanol solution of 4.0 g of tributyldodecylphosphonium bromide (Tokyo Chemical Industry Co., Ltd.) was added to 16 mL of an anion exchange resin (DS-2, Organo Corporation) which had been washed with ion-exchanged water and then subjected to solvent replacement with methanol (Wako Pure Chemical Industries, Ltd.), and the mixture was left overnight (the indicated volume of the resin is inclusive of added methanol, and the same applies hereinafter). DS-2 was removed by filtration, and the filtrate was added to 16 mL of washed, methanol-replaced DS-2 freshly prepared. The mixture was left overnight, and then DS-2 was removed by filtration. Next, the filtrate was passed through a column packed with 32 mL of DS-2 (eluent: methanol), and a filtrate showing alkalinity was collected. Thus, a methanol solution of tributyldodecylphosphonium hydroxide resulting from complete replacement of bromide by hydroxide was obtained.

An aqueous solution prepared by dissolving 14.5 g of a silicon-containing phosphate salt ([Chemical formula 26]) in 18 mL of water was added to 17 mL of a cation exchange resin (Amberlist 15JS-HG•DRY, manufactured by Organo Corporation) washed with ion-exchanged water (the indicated volume of the resin is inclusive of added ion-exchanged water), and the mixture was stirred for 6 hours. 15JS-HG•DRY was removed by filtration, and the filtrate was added to 17 mL of washed 15JS-HG•DRY freshly prepared. After stirring overnight, 15JS-HG•DRY was removed by filtration, as a result of which a white filtrate was obtained. The filtrate was transferred to a separatory funnel and subjected to extraction with ethyl acetate. The separated aqueous layer was further subjected to extraction with ethyl acetate, and the extracts (organic layers) were collected and washed with water three times. Thus, an ethyl acetate solution of an acid corresponding to the ionic compound the cationic moieties of which are completely replaced by hydrogen ions (protons) was obtained.

Hereinafter, the room-temperature ionic liquid shown in [Chemical formula 28] may be referred to as "BDDP•TMSC3PO4".

The obtained methanol solution of tributyldodecylphosphonium hydroxide and the obtained ethyl acetate solution of the acid were mixed to give a pH of 6 to 8. This mixed solution was subjected to solvent removal with an evaporator first and then with a vacuum pump. Thus, the target compound, namely the ionic compound, was obtained as a viscous liquid (amount: 4.3 g, yield on a tributyldodecylphosphonium bromide basis: 81%).

The following ionic compound was also successfully obtained by the same synthesis method except that tributylhexadecylphosphonium bromide Tokyo Chemical Industry Co., Ltd.) was used in place of tributyldodecylphosphonium bromide (yield: 93%). This ionic compound was liquid at room temperature. Also in this case, the alkyl groups contained in the cation of the following ionic compound are all linear.

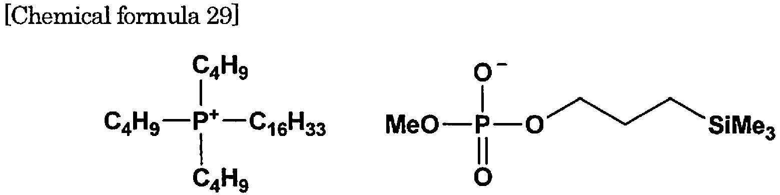

Synthesis of other ionic compounds containing a phosphate ester ion group-containing anion is not described herein since they can be synthesized by referring as appropriate to the schemes and synthesis examples described above.

### <Mixing ratio between light-emitting material and ionic compound>

The optimal value of the mixing ratio between the light-emitting material and ionic compound used in the light-emitting layer 3 varies depending on the combination of the light-emitting material and ionic compound. In general, the ratio between the light-emitting material and ionic compound, as expressed by the number of moles (mol/g) of the ionic compound per unit mass (1 g) of the light-emitting material, is preferably 1.0 × 10⁻⁵ to 1.0 × 10⁻², more preferably 5.0 × 10⁻⁵ to 5.0 × 10⁻³, even more preferably 7.0 × 10⁻⁵ to 3.0 × 10⁻³, particularly preferably 1.0 × 10⁻⁴ to 1.0 × 10⁻³, more particularly preferably 1.2 × 10⁻⁴ to 5.0 × 10⁻⁴, and, in some cases, 1.5 × 10⁻⁴ to 4.0 × 10⁻⁴.

### <Method for producing light-emitting electrochemical cell>

The light-emitting electrochemical cell 11 of the present embodiment can be produced, for example, by the following production method. First, the substrate 5 provided with the first electrode 1 is prepared and, if necessary, the first electrode 1 is patterned into a predefined form. The patterned first electrode 1 can be obtained, for example, by performing a photolithography process, or a combination of a photolithography process and lift-off process, on ITO.

Next, the light-emitting layer 3 is formed on the first electrode 1. It is recommended that the light-emitting layer be formed by so-called wet film formation using a light-emitting layer-forming solution. The light-emitting layer-forming solution can be prepared, for example, by dissolving an ionic compound and a light-emitting material in an organic solvent. The organic solvent may be selected as appropriate depending on the types of the materials to be dissolved. It is recommended to use toluene, benzene, tetrahydrofuran, dimethyl chloride, chlorobenzene, or chloroform, especially when an organic high-molecular-weight light-emitting material is used. The method for applying the light-emitting layer-forming solution is not particularly limited and, for example, spin coating or roll coating may be employed. After the application of the solution, the organic solvent is evaporated, if necessary by heating, and thus the light-emitting layer 3 is formed. It is preferable that the preparation and application of the light-emitting layer-forming solution be carried out in a low-humidity atmosphere, in particular an atmosphere with a water content of 100 ppm or less, such as a humidity-controlled atmosphere of inert gas. A so-called noble gas such as argon or helium may be used as the inert gas, and nitrogen may also be used as the inert gas.

Next, the second electrode 2 is formed on the light-emitting layer 3. The second electrode 2 can be formed, for example, by depositing a metal film, such as typically an aluminum (Al) film, by vacuum deposition using a mask. Thus, the light-emitting electrochemical cell 11 shown in FIG. 1 is obtained. The light-emitting electrochemical cell 11 may, if necessary, be vacuum-dried to improve the film quality of the light-emitting layer 3. The vacuum drying can be carried out at room temperature or under heating.

### EXAMPLES

In Examples and Comparative Examples described below, light-emitting electrochemical cells were produced, each of which had a structure consisting of, in order from the substrate, glass (substrate)/ITO (first electrode)/PEDOT:PSS (hole injection layer)/SY + ionic compound (light-emitting layer)/Al (second electrode).

### (Example 1)

A hole injection layer (PEDOT-PSS, manufactured by Heraeus) was formed by spin coating (film thickness: 50 nm) on a commercially-sold ITO-coated glass substrate (manufactured by GEOMATEC Co., Ltd.; ITO film thickness: 150 nm). SY (Super Yellow, manufactured by Merck & Co., Inc.) was dissolved in dichlorobenzene to prepare a 0.46 wt% solution. The dichlorobenzene solution of SY and a dichlorobenzene solution of BDDP•TMSC3SO3 (concentration: about 18 mmol/kg) were mixed in a mass ratio of 15:1 to give a light-emitting layer-forming solution. In this mixed solution, the number of moles of BDDP•TMSC3SO3 added per 1 g of SY was 2.6 × 10⁻⁴ mol. Next, the light-emitting layer-forming solution was applied by spin coating onto the PEDOT:PSS layer to form a light-emitting layer. The application of the light-emitting layer was followed by heating on a hot plate at 70°C for 30 minutes to remove dichlorobenzene, and thus a 100-nm-thick light-emitting layer made of SYBDDP•TMSC3SO3 was formed. A 100-nm-thick Al electrode was formed by vacuum deposition on the light-emitting layer, and thus a light-emitting electrochemical cell was produced. BDDP•TMSC3SO3 used in the light-emitting layer was synthesized by the method disclosed in JP 2013-14536 A referred to above.

### (Examples 2 to 7)

Light-emitting electrochemical cells were produced in the same manner as in Example 1, except that ionic compounds listed in Table 1 were used instead of BDDP•TMSC3SO3, and the light emission characteristics of the light-emitting electrochemical cells were evaluated. It should be noted that the number of moles of the ionic compound per 1 g of SY was the same as in Example 1. The ionic compounds were synthesized by the methods referred to or described above.

### (Comparative Examples 1 to 7)

Light-emitting electrochemical cells were produced in the same manner as in Example 1, except that ionic compounds listed in Table 1 were used instead of BDDP•TMSC3SO3, and the light emission characteristics of the light-emitting electrochemical cells were evaluated. It should be noted that the number of moles of the ionic compound per 1 g of SY was the same as in Example 1.

In Table 1, "BDDP" denotes tributyldodecylphosphonium, "BHDP" denotes tributylhexadecylphosphonium, "DDS" denotes dodecyl sulfate, "PTS" denotes p-toluene sulfonate, "TF' denotes trifluoromethane sulfonate, "PF6" denotes hexafluorophosphate, "TFSI" denotes bis(trifluoromethanesulfonyl)imide, and "BS" denotes butanesulfonate (butanesulfonic acid). The alkyl group contained in DDS is an n-dodecyl group.

The phosphonium salts listed for Comparative Examples were synthesized by known synthesis methods as described below. For BDDP•PF6 (Comparative Example 4), BDDP•TFSI (Comparative Example 5), and BHDP•PF6 (Comparative Example 6) which are hydrophobic, a lithium salt of the corresponding anion was mixed in an excess molar ratio with an aqueous solution of the corresponding phosphonium halide, and the reaction was allowed to proceed. After stirring overnight, the organic layer of the resulting two separate layers was separated, and the aqueous layer was extracted with ethyl acetate. The organic layers were combined and washed with distilled water about five times. After that, the solvent was distilled off, and water was removed with a vacuum pump under heating at about 100°C. The phosphonium salts were thus obtained. BDDP•TFSI was liquid at room temperature, while BDDP•PF6 and BHDP•PF6 were solid at room temperature. The lithium salts of the corresponding anions, namely lithium hexafluorophosphate (LiPF6) and lithium bis(trifiuoromethanesulfonyl) imide (LiTFSI), are both commercially sold and commonly available.

The other phosphoniums salts, namely BDDP•DDS (Comparative Example 1), BDDP•PTS (Comparative Example 2), BDDP•TF (Comparative Example 3), and BHDP•BS (Comparative Example 7), were synthesized using a neutralization process according to the above-described synthesis method of ionic compounds containing an anion represented by the formula (1-1). BDDP•DDS, BDDP•PTS, and BDDP•TF were liquid at room temperature, while BHDP•BS was solid at room temperature.

The anion sources used were sodium salts of the corresponding anions. That is, DDS was synthesized using sodium dodecyl sulfate, PTS was synthesized using sodium p-toluenesulfonate, TF was synthesized using sodium trifluoromethanesulfonate, and BS was synthesized using sodium butanesulfonate. These anion sources are sold as reagents and are commonly available.

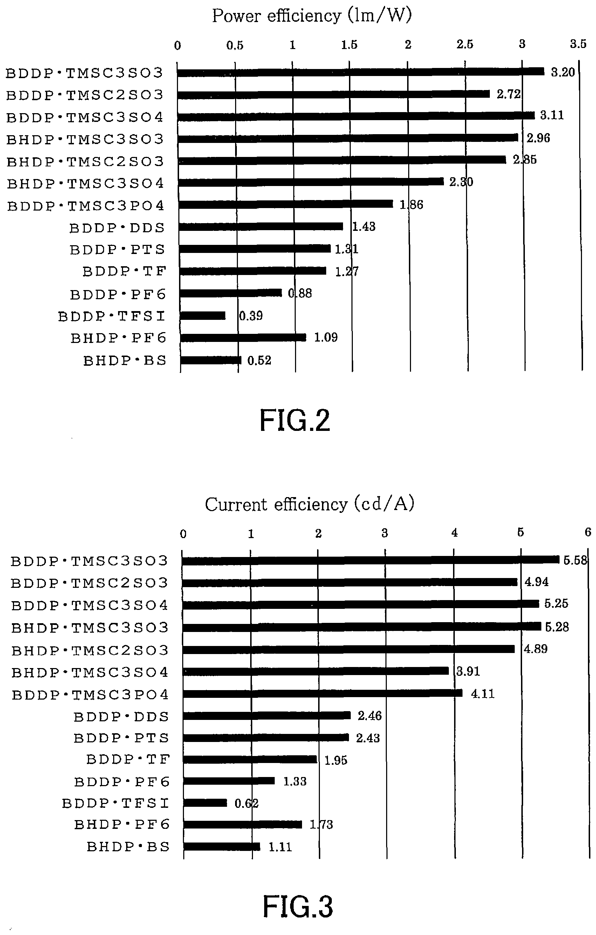

The light emission characteristics (luminance-current-voltage characteristics) of the light-emitting electrochemical cells produced in Examples and Comparative Examples were evaluated. The DC voltage applied was varied by increments of 0.1 V up to 10 V. The luminance of light passing through the glass substrate was measured, and the light emission efficiency for light emission at 1000 cd/m² was calculated. The results are shown in Table 1, FIG. 2, and FIG. 3. All the values are data obtained in the fifth measurement.

**[Table 1]**

| | Ionic compound | Light emission efficiency | |
|---|---|---|---|
| | | Power efficiency (lm/W) | Current efficiency (cd/A) |
| Example 1 | BDDP•TMSC3SO3 | 3.20 | 5.58 |
| Example 2 | BDDP•TMSC2SO3 | 2.72 | 4.94 |
| Example 3 | BDDP•TMSC3SO4 | 3.11 | 5.25 |
| Example 4 | BHDP•TMSC3SO3 | 2.96 | 5.28 |
| Example 5 | BHDP•TMSC2SO3 | 2.85 | 4.89 |
| Example 6 | BHDP•TMSC3SO4 | 2.30 | 3.91 |
| Example 7 | BDDP•TMSC3PO4 | 1.86 | 4.11 |
| Comparative Example 1 | BDDP•DDS | 1.43 | 2.46 |
| Comparative Example 2 | BDDP•PTS | 1.31 | 2.43 |
| Comparative Example 3 | BDDP•TF | 1.27 | 1.95 |
| Comparative Example 4 | BDDP•PF6 | 0.88 | 1.33 |
| Comparative Example 5 | BDDP•TFSI | 0.39 | 0.62 |
| Comparative Example 6 | BHDP•PF6 | 1.09 | 1.73 |
| Comparative Example 7 | BHDP•BS | 0.52 | 1.11 |

| | | | |
|---|---|---|---|
| * Both the power efficiency and current efficiency are those calculated for light emission at 1000 cd/m² (fifth measurement). | | | |

From Table 1 and FIGS. 2 and 3, it can be understood that the devices employing an anion having a silicon-containing group (Examples 1 to 7) have an improved power efficiency and improved current efficiency, compared to the devices employing an anion containing no silicon (Comparative Examples 1 to 7). In Examples employing an anion having a silicon-containing group, despite the fact that the number of carbon atoms in the alkyl or alkylene groups contained in the anion was 3 or less for each group and 6 or less in total, the light emission efficiency was higher than in Comparative Example 1 employing an anion having alkyl groups in which the number of carbon atoms was about twice that in the alkyl or alkylene groups in Examples. A possible reason why higher light emission efficiency was achieved by the light-emitting electrochemical cells of Examples 1 to 7 involves the presence of the silicon element contained in the anion. By comparison among Examples 1, 3, and 7 where the same cation was used and the anions were different only in the oxoanion group, it can be understood that oxoanion groups particularly suitable for improvement in light emission efficiency are -SO₃- and -OSO₃-.

### (Example 8)

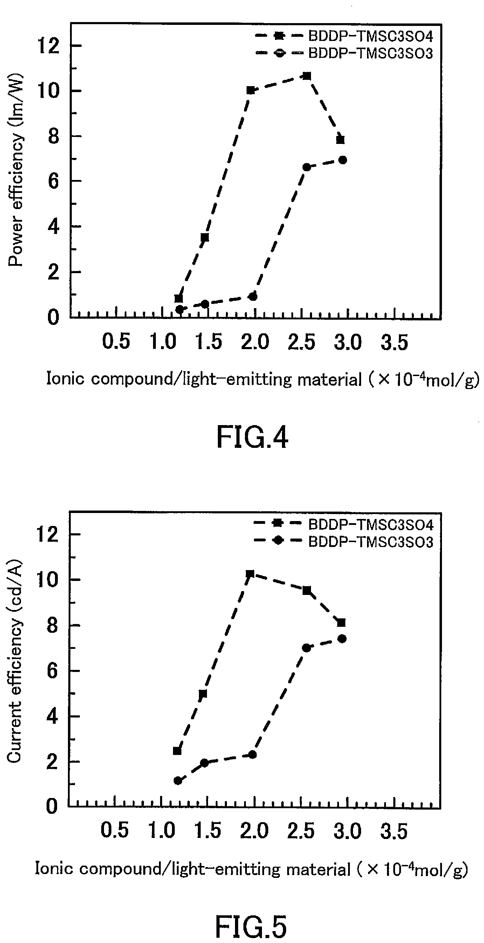

Light-emitting electrochemical cells were produced in the same manner as in Examples 1 and 3, except that the numbers of moles (mol/g) of BDDP•TMSC3SO3 and BDDP•TMSC3SO4 added per 1 g of SY were 1.2 × 10⁻⁴, 1.5 × 10⁻⁴, 2.0 × 10⁻⁴, 2.6 × 10⁻⁴, and 2.9 × 10⁻⁴, and the light emission characteristics of the light-emitting electrochemical cells were evaluated. The results for the maximum light emission efficiency achieved in the measurement are shown in FIG. 4 and FIG. 5.

From FIGS. 4 and 5, it can be concluded that the appropriate amount of the ionic compound added to the light-emitting material, as expressed by the number of moles (mol/g) of the ionic compound added per unit weight of SY used as the light-emitting material, is generally about 1 × 10⁻⁴ to 4.5 × 10⁻⁴, and that the optimal amount is about 1.5 × 10⁻⁴ to 3.5 × 10⁻⁴ for BDDP•TMSC3SO4 and about 2.0 × 10⁻⁴ to 4.0 × 10⁻⁴ for BDDP•TMSC3SO3. For both BDDP•TMSC3SO3 and BDDP•TMSC3SO4, it was confirmed that, although precise measurement was not performed, the addition of an ionic compound in an amount of more than 3.7 × 10⁻⁴ mol/g results in much lower power efficiency and current efficiency than the addition of the ionic compound in an amount of 3.0 × 10⁻⁴ mol/g.

## Claims

1. A light-emitting electrochemical cell comprising a first electrode, a second electrode, and a light-emitting layer disposed between the first electrode and the second electrode, wherein
the light-emitting layer contains an ionic compound, and
**characterized in that**
the ionic compound contains an anion having a silicon atom.

2. The light-emitting electrochemical cell according to claim 1, wherein the anion has a silicon-containing group represented by the following formula (1a) and an anion group: 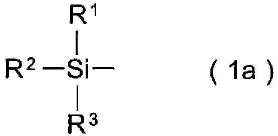 wherein R¹, R², and R³ are each independently an alkyl group having 1 to 4 carbon atoms, and two alkyl groups selected from R¹, R², and R³ are optionally bonded to each other to form an alkylene group having 4 or 5 carbon atoms and constituting a cyclic structure together with the silicon atom.

3. The light-emitting electrochemical cell according to claim 2, wherein the anion group is an oxoanion group.

4. The light-emitting electrochemical cell according to claim 2, wherein the anion group is represented by -SO₃-, -OSO₃-, or -OP(OR⁰)O₂-, wherein R⁰ is an alkyl group having 1 to 4 carbon atoms.

5. The light-emitting electrochemical cell according to claim 4, wherein the anion group is represented by -SO₃- or -OSO₃-.

6. The light-emitting electrochemical cell according to claim 2, wherein the silicon-containing group and the anion group are bonded via an alkylene group having 2 to 12 carbon atoms.

7. The light-emitting electrochemical cell according to claim 1, wherein the anion is represented by the following formula (1): 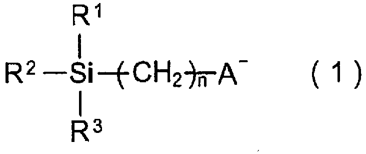 wherein n is an integer of 2 to 6 and A- is an anion group.

8. The light-emitting electrochemical cell according to claim 7, wherein R¹, R², and R³ are methyl groups, and n is 2 or 3.

9. The light-emitting electrochemical cell according to claim 1, wherein the ionic compound contains a cation, and the cation is at least one selected from a nitrogen atom-containing ion, a phosphorus atom-containing ion, a metal ion, and an organic metal complex ion.

10. The light-emitting electrochemical cell according to claim 9, wherein the ionic compound contains at least one cation selected from a quaternary ammonium ion, a quaternary phosphonium ion, an imidazolium ion, and a pyridinium ion.

11. The light-emitting electrochemical cell according to claim 1, wherein in the light-emitting layer, the number of moles of the ionic compound per 1 g of the light-emitting material is 1.0 × 10⁻⁵ to 1.0 × 10⁻².

12. The light-emitting electrochemical cell according to claim 11, wherein in the light-emitting layer, the number of moles of the ionic compound per 1 g of the light-emitting material is 1.2 × 10⁻⁴ to 5.0 × 10⁻⁴.

## Patentansprüche

1. Lichtemittierende elektrochemische Zelle, die eine erste Elektrode, eine zweite Elektrode und eine lichtemittierende Schicht umfasst, die zwischen der ersten Elektrode und der zweiten Elektrode angeordnet ist, wobei
die lichtemittierende Schicht eine ionische Verbindung enthält, und
**dadurch gekennzeichnet, dass**
die ionische Verbindung ein Anion enthält, das ein Siliziumatom aufweist.

2. Lichtemittierende elektrochemische Zelle nach Anspruch 1, wobei das Anion eine siliziumhaltige Gruppe, die durch die folgende Formel (1a) dargestellt ist, und eine Anionengruppe aufweist: 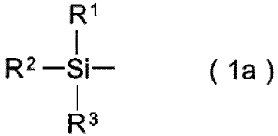 wobei R¹, R² und R³ jeweils unabhängig eine Alkylgruppe sind, die 1 bis 4 Kohlenstoffatome aufweist, und zwei Alkylgruppen ausgewählt aus R¹, R² und R³ optional aneinander gebunden sind, um eine Alkylengruppe zu bilden, die 4 oder 5 Kohlenstoffatome aufweist und zusammen mit dem Siliziumatom eine cyclische Struktur bildet.

3. Lichtemittierende elektrochemische Zelle nach Anspruch 2, wobei die Anionengruppe eine Oxoanionengruppe ist.

4. Lichtemittierende elektrochemische Zelle nach Anspruch 2, wobei die Anionengruppe durch -SO₃-, -OSO₃- oder -OP(OR⁰)O₂- dargestellt ist, wobei R⁰ eine Alkylgruppe ist, die 1 bis 4 Kohlenstoffatome aufweist.

5. Lichtemittierende elektrochemische Zelle nach Anspruch 4, wobei die Anionengruppe durch -SO₃-, oder -OSO₃- dargestellt ist.

6. Lichtemittierende elektrochemische Zelle nach Anspruch 2, wobei die siliziumhaltige Gruppe und die Anionengruppe über eine Alkylengruppe gebunden sind, die 2 bis 12 Kohlenstoffatome aufweist.

7. Lichtemittierende elektrochemische Zelle nach Anspruch 1, wobei das Anion durch die folgende Formel (1) dargestellt ist: 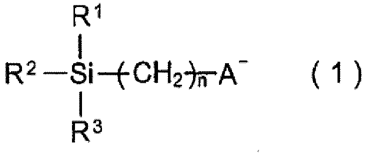 wobei n eine ganze Zahl von 2 bis 6 ist und A⁻ eine Anionengruppe ist.

8. Lichtemittierende elektrochemische Zelle nach Anspruch 7, wobei R¹, R² und R³ Methylgruppen sind und n 2 oder 3 ist.

9. Lichtemittierende elektrochemische Zelle nach Anspruch 1, wobei die ionische Verbindung ein Kation enthält und das Kation zumindest eines ausgewählt aus einem stickstoffatomhaltigen Ion, einem phosphoratomhaltigen Ion, einem Metallion und einem organischen Metallkomplexion ist.

10. Lichtemittierende elektrochemische Zelle nach Anspruch 9, wobei die ionische Verbindung zumindest ein Kation enthält, das aus einem quaternären Ammoniumion, einem quaternären Phosphoniumion, einem Imidazoliumion und einem Pyridiniumion ausgewählt ist.

11. Lichtemittierende elektrochemische Zelle nach Anspruch 1, wobei in der lichtemittierenden Schicht die Anzahl an Mol der ionischen Verbindung pro 1 g des lichtemittierenden Materials 1,0 × 10⁻⁵ bis 1,0 × 10⁻² ist.

12. Lichtemittierende elektrochemische Zelle nach Anspruch 11, wobei in der lichtemittierenden Schicht die Anzahl an Mol der ionischen Verbindung pro 1 g des lichtemittierenden Materials 1,2 × 10⁻⁴ bis 5,0 × 10⁻⁴ ist.

## Revendications

1. Cellule électroluminescente électrochimique comprenant une première électrode, une seconde électrode et une couche électroluminescente disposée entre la première électrode et la seconde électrode, dans laquelle
la couche électroluminescente contient un composé ionique, et **caractérisée en ce que**
le composé ionique contient un anion présentant un atome de silicium.

2. Cellule électroluminescente électrochimique selon la revendication 1, dans laquelle l'anion présente un groupe contenant du silicium représenté par la formule (1a) suivante et un groupe d'anion : 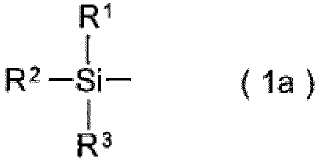 dans laquelle R¹, R², et R³ sont chacun indépendamment un groupe alkyle ayant de 1 à 4 atomes de carbone, et deux groupes alkyle choisis parmi R¹, R², et R³ sont éventuellement liés l'un à l'autre pour former un groupe alkylène ayant 4 ou 5 atomes de carbone et constituant une structure cyclique avec l'atome de silicium.

3. Cellule électroluminescente électrochimique selon la revendication 2, dans laquelle le groupe anion est un groupe oxoanion.

4. Cellule électroluminescente électrochimique selon la revendication 2, dans laquelle le groupe d'anion est représenté par -SO₃⁻, -OSO₃⁻, ou -OP(OR⁰)O₂-, dans laquelle R⁰ est un groupe alkyle ayant de 1 à 4 atomes de carbone.

5. Cellule électroluminescente électrochimique selon la revendication 4, dans laquelle le groupe d'anion est représenté par -SO₃⁻ou -OSO₃⁻-

6. Cellule électroluminescente électrochimique selon la revendication 2, dans laquelle le groupe contenant du silicium et le groupe d'anion sont liés via un groupe alkylène ayant de 2 à 12 atomes de carbone.

7. Cellule électroluminescente électrochimique selon la revendication 1, dans laquelle l'anion est représenté par la formule (1) suivante : 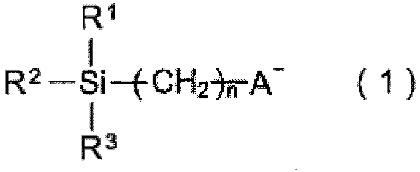 dans laquelle n est un nombre entier de 2 à 6 et A⁻ est un groupe d'anion.

8. Cellule électroluminescente électrochimique selon la revendication 7, dans laquelle R¹, R², et R³ sont des groupes méthyle, et n est égal à 2 ou 3.

9. Cellule électroluminescente électrochimique selon la revendication 1, dans laquelle le composé ionique contient un cation, et le cation est au moins un choisi parmi un ion contenant un atome d'azote, un ion contenant un atome de phosphore, un ion de métal, et un ion de complexe de métal organique.

10. Cellule électroluminescente électrochimique selon la revendication 9, dans laquelle le composé ionique contient au moins un cation choisi parmi un ion ammonium quaternaire, un ion phosphonium quaternaire, un ion imidazolium, et un ion pyridinium.

11. Cellule électroluminescente électrochimique selon la revendication 1, dans laquelle dans la couche électroluminescente, le nombre de moles du composé ionique pour 1 g du matériau électroluminescent est de 1,0 × 10⁻⁵ à 1,0 × 10⁻².

12. Cellule électroluminescente électrochimique selon la revendication 11, dans laquelle dans la couche électroluminescente, le nombre de moles du composé ionique pour 1 g du matériau électroluminescent est de 1,2 × 10⁻⁴ à 5,0 × 10⁻⁴.
